# EUROPÄISCHE PATENTSCHRIFT

(11) **EP 1 922 774 B1**
(45) Veröffentlichungstag und Bekanntmachung des Hinweises auf die Patenterteilung: **13.06.2012**
(21) Anmeldenummer: 06777163.4
(22) Anmeldetag: 05.09.2006
(51) Int. Cl.: H01L 27/28

(54) **ORGANISCHES BAUELEMENT UND EIN SOLCHES UMFASSENDE ELEKTRISCHE SCHALTUNG**
ORGANIC COMPONENT AND ELECTRIC CIRCUIT COMPRISING SAID COMPONENT
COMPOSANT ORGANIQUE ET CIRCUIT ELECTRIQUE COMPORTANT UN TEL COMPOSANT

(30) Priorität: 06.09.2005 DE 102005042166
(43) Veröffentlichungstag der Anmeldung: 21.05.2008
(73) Patentinhaber: PolyIC GmbH & Co. KG, 90763 Fürth (DE)
(72) Erfinder: ULLMANN, Andreas, 90513 Zirndorf (DE); FIX, Walter, 90763 Fürth (DE)
(74) Vertreter: Zinsinger, Norbert
(86) Internationale Anmeldenummer: PCT/EP2006/008623
(87) Internationale Veröffentlichungsnummer: WO 2007/028566

(56) Entgegenhaltungen:
- EP-A- 0 588 721
- WO-A2-03/081671
- JP-A- 5 152 560
- US-A1- 2004 151 014
- US-A1- 2005 029 514
- US-B1- 6 335 539
- SIRRINGHAUS H ET AL: "HIGH-RESOLUTION INKJET PRINTING OF ALL-POLYMER TRANSISTOR CIRCUITS" SCIENCE, AMERICAN ASSOCIATION FOR THE ADVANCEMENT OF SCIENCE,, US, Bd. 290, 15. Dezember 2000 (2000-12-15), Seiten 2123-2126, XP001013911 ISSN: 0036-8075
- KAWASE T ET AL: "INKJET PRINTED VIA-HOLE INTERCONNECTIONS AND RESISTORS FOR ALL-POLYMER TRANSISTOR CIRCUITS" ADVANCED MATERIALS, WILEY VCH, WEINHEIM, DE, Bd. 13, Nr. 21, 2. November 2001 (2001-11-02), Seiten 1601-1605, XP001129628 ISSN: 0935-9648

## Beschreibung

Die Erfindung betrifft ein neuartiges organisches Last-Bauelement, nachfolgend Auator genannt, sowie eine elektrische Schaltung umfassend mindestens einen solchen Auator.

Wie bereits in WO 03/081671 beschrieben, sind logische Gatter wie beispielsweise NAND, NOR oder Inverter die elementaren Bestandteile einer integrierten digitalen elektronischen Schaltung. Die Schaltgeschwindigkeit der integrierten Schaltung hängt dabei von der Geschwindigkeit der logischen Gatter und nicht von der Geschwindigkeit der einzelnen Transistoren ab. In der herkömmlichen Silizium-Halbleitertechnologie werden diese Gatter durch Verwendung von sowohl n- als auch p-leitenden Transistoren realisiert und sind dadurch sehr schnell. Bei organischen Schaltungen ist das schwer realisierbar, weil es keine ausreichend guten n-Halbleiter gibt (z.B. im Hinblick auf die Ladungsträger-Beweglichkeit). Für organische Schaltungen bedeutet das, dass ein klassischer Widerstand anstelle des n-leitenden Transistors eingesetzt wird. Als "klassischer Widerstand" wird hier ein Bauelement mit einer linearen Strom-Spannungs-Kennlinie bezeichnet. Nachteilig an solchen logischen Gattern mit organischen Feldeffekt-Transistoren ist, dass sie entweder langsam umschalten (wenn die Umladeströme, also die Integrale unter der Strom- Spannungskurve sehr verschieden sind) oder sich nicht ausschalten lassen (wenn der Spannungshub im Strom-Spannungs-Diagramm zu gering ist).

Um klassische Widerstände im Megaohm-Bereich auszubilden, werden sehr dünne und lange Leiterbahnen aus elektrisch leitfähigem Material (metallische oder organische Leiter) erzeugt. Derartig ausgebildete Widerstände müssen separat gebildet werden und passen sich einem p-FET in einem logischen Gatter nicht an, wenn die Schichtdicke des Halbleiters im p-FET herstellungsbedingt schwankt, so dass keine Schaltung mit reproduzierbaren Eigenschaften oder gar keine funktionierende Schaltung gebildet werden kann.

Gemäß der WO 03/081671 wurden bereits verbesserte logische Gatter mit organischen Feldeffekt-Transistoren geschaffen, bei welchen die fehlenden "klassischen" n-leitenden Transistoren nicht durch klassische Widerstände, sondern einen organischen p-leitenden Feldeffekt-Transistor (p-OFET), ersetzt wurden.

Durch die Verwendung eines p-OFET anstelle eines n-leitenden Transistors wird allerdings eine zusätzliche parasitäre Kapazität - die Transistorkapazität - in das logische Gatter eingebaut, die die Schaltungseigenschaften negativ beeinflusst.

Es ist nun Aufgabe der Erfindung, ein alternatives Last-Bauelement für ein schnelles logisches Gatter aufzufinden, das mit niedriger Versorgungsspannung betrieben werden kann und sich bei Schwankungen in der Dicke einer Halbleiterschicht in einem p-FET entsprechend anpasst. Weiterhin ist es Aufgabe der Erfindung, geeignete elektrische Schaltungen für ein solches logisches Gatter aufzuzeigen.

Die Aufgabe wird für das Last-Bauelement durch ein organisches Last-Bauelement gemäß Anspruch 1, nachfolgend Auator genannt, gelöst.

Es hat sich gezeigt, dass nur mit einem solchen Aufbau eine stabile Strom-Spannungs-Charakteristik für das erfindungsgemäße organische Bauelement sichergestellt ist. Wird nämlich die erste Isolatorschicht weggelassen, entsteht kein brauchbares Bauelement. Die Ursachen für das stabilisierende Verhalten der ersten Isolatorschicht sind noch nicht vollständig geklärt.

Da die Elektrodenschichten des Auators sich in der gleichen Ebene nebeneinander befinden und zudem sehr dünn ausgebildet werden können, besitzt der Auator annähernd keine Kapazität. Über die Geometrie der Elektrodenschichten und die Ausbildung der organischen Halbleiterschicht ist der Stromfluss optimal einstellbar.

Der erfindungsgemäße Auator stellt ein alternatives Last-Bauelement für ein schnelles logisches Gatter bereit, das mit einer niedrigen Versorgungsspannung im Bereich von -1 Volt bis -100 Volt betrieben werden kann.

Ähnliche organische Last-Bauelemente werden in EP 0 588 721 und US 2004/0151 014 beschrieben.

Der Auator kann aufgrund der Schichtfolge seiner einzelnen Schichten und der erforderlichen Schichtmaterialien sehr einfach zusammen mit den Schichten eines p-FET ausgebildet werden. So bietet es sich an, die Source- und Drain-Elektroden des p-FET und die erste und die zweite Elektrodenschicht des Auators in einem Arbeitsgang auf einem Substrat in gleicher Ebene und aus gleichem Material auszubilden und weiterhin die Halbleiterschicht des p-FET und die Halbleiterschicht des Auators in einem Arbeitsgang auf den Elektrodenschichten in gleicher Ebene und aus gleichem Material auszubilden. Dies gewährleistet, dass die Dicke der Halbleiterschicht des Auators und des p-FET gleich dick ausgebildet werden und somit der Auator sich in seinen elektrischen Eigenschaften direkt an den p-FET anpasst.

Es hat sich bewährt, wenn der Auator eine zweite Isolatorschicht aufweist, welche die organische Halbleiterschicht im Bereich des Abstandes A zwischen der ersten und der zweiten Elektrodenschicht bedeckt. Dies schützt die organische Halbleiterschicht auch auf der, der ersten Isolatorschicht gegenüber liegenden Seite vor etwaigen Umgebungseinflüssen.

Vorzugsweise bedeckt die zweite Isolatorschicht weiterhin die der organischen Halbleiterschicht abgewandten Seiten der beiden Elektrodenschichten. So sind auch diese vor Umgebungseinflüssen geschützt.

Weiterhin hat es sich als zweckmäßig erwiesen, wenn die zweite Isolatorschicht als mechanischer Träger, insbesondere als flexibler mechanischer Träger, fungiert. Dabei kann der Träger auch mehrlagig ausgebildet sein und je nach den gewünschten Eigenschaften Papier-, Kunststoff-, Metall-, Gewebeschichten oder anorganische Schichten umfassen, wobei die Schichtlage des Trägers, welche an die Elektrodenschichten und die Halbleiterschicht angrenzt, jedoch grundsätzlich elektrisch isolierend als zweite Isolatorschicht ausgebildet sein muss. Vorzugsweise wird der Träger durch eine Folie aus PET, PVP, Polyamid, PP, PEN, Polyimid, Glas, Glas-beschichtetem Kunststoff, Polykarbonat oder aus - gegebenenfalls mit Kunststoff beschichtetem - Papier bereitgestellt.

Der Abstand A zwischen der ersten Elektrodenschicht und der zweiten Elektrodenschicht beträgt 1 µm bis 100µm.

Es hat sich bewährt, wenn die Elektrodenschichten jeweils eine Schichtdicke im Bereich von 1nm bis 10µm, insbesondere von 1nm bis 100nm aufweisen.

Es ist bevorzugt, das erste und das zweite elektrisch leitende Material zur Bildung der Elektrodenschichten aus Metall, einer Metall-Legierung, einem leitfähigen Polymer, einem leitfähigen Kleber, einer leitfähigen Substanz mit leitfähigen anorganischen Partikeln in einer Polymermatrix oder aus einer Paste/Tinte enthaltend elektrisch leitfähige Partikel zu bilden.

Dabei können die Elektrodenschichten mehrschichtig ausgebildet sein, insbesondere aus mehreren Metallschichten und/oder mehreren Polymerschichten und/oder mehreren Pasten/Tinten-Schichten gebildet sein.

Die organische Halbleiterschicht weist eine Schichtdicke im Bereich von 1nm bis 200 nm auf.

Die erste Isolatorschicht weist bevorzugt eine Schichtdicke im Bereich von 1nm bis 10µm, insbesondere im Bereich von 200nm bis 800nm auf.

Es hat sich als günstig erwiesen, wenn die zweite Isolatorschicht eine Schichtdicke von mindestens 1µm, bevorzugt von etwa 50µm aufweist.

Es ist bevorzugt, die organische Halbleiterschicht aus Polythiophen, Polyterthiophen, Polyfluoren, Pentacen, Tetracen, Oligothiophen, anorganischem Silizium eingebettet in Polymermatrix, Nano-Silizium oder Polyarylamin zu bilden.

Weiterhin hat es sich als vorteilhaft erwiesen, die erste Isolatorschicht als eine organische Polymerschicht auszubilden, insbesondere aus Polymethylmethacrylat (PMMA), PVP, PHS, PS, Polystyrolcopolymeren, Harnstoffharzen oder PMMA-Copolymeren zu bilden.

Im Hinblick auf eine kostengünstige Herstellung des Auators ist es bevorzugt, wenn zumindest die organische Halbleiterschicht mittels einer Flüssigkeit, insbesondere durch ein Druckverfahren, gebildet ist. Dabei sind insbesondere kontinuierliche Druckverfahren, bei welchen ein Foliensubstrat von Rolle zu Rolle gefördert und mit den Funktionsschichten des Auators und gegebenenfalls weiterer Bauelemente zur Ausbildung einer elektrischen Schaltung bedruckt wird, bevorzugt. Geeignet sind hier aber nicht nur klassische Druckverfahren sondern auch ein Besprühen, Beschichten, Rakeln oder ein sonstiges Auftragsverfahren, das als kontinuierlicher Prozess gefahren werden kann.

Die Aufgabe wird weiterhin für die elektrische Schaltung dadurch gelöst, dass diese mindestens einen wie oben beschriebenen Auator umfasst, wobei die elektronische Schaltung ein logisches Gatter bildet.

Dabei hat es sich bewährt, wenn das logische Gatter mindestens ein Treiber-Bauelement und mindestens ein Last-Bauelement aufweist, wobei das mindestens eine Treiber-Bauelement durch einen Transistor und das mindestens eine Last-Bauelement durch den Auator bereitgestellt ist. Weiterhin hat es sich hier als vorteilhaft erwiesen, wenn als Transistor ein organischer Feldeffekt-Transistor (OFET) eingesetzt ist, der vorzugsweise ein p-leitender OFET ist.

So kann bei Herstellung der elektrischen Schaltung, vorzugsweise mittels eines Druckvorgangs, die Halbleiterschicht des Transistors gleichzeitig und in einem Arbeitsgang mit der organischen Halbleiterschicht des Auators gebildet werden. Treten bei der organischen Halbleiterschicht fertigungsbedingt Schichtdickenschwankungen auf, so werden dadurch nicht nur die Eigenschaften des Transistors verändert, sondern im gleichen Ausmaß auch die Werte des Auators, wodurch die Funktion des logischen Gatters erhalten bleibt.

Wie bereits weiter oben erläutert, ist aufgrund des ähnlichen Schichtaufbaus und der ähnlichen Schichtfolgen für Auator und insbesondere p-OFET eine gemeinsame Herstellung von einzelnen Schichten dieser Bauelemente in einem einzigen Arbeitsgang leicht und unproblematisch durchführbar, wobei gleiche Schichtmaterialien zum Einsatz kommen. Die organische Halbleiterschicht wird dabei so großflächig ausgebildet, dass sowohl der Auator als auch der p-OFET davon partizipieren.

Das logische Gatter bildet vorzugsweise einen Inverter, ein logisches Nicht-Oder, ein logisches Nicht-Und oder - einen aus Invertern zusammengesetzten - Ringoszillator.

Es hat sich bewährt, wenn der Inverter mindestens einen p-leitenden OFET und mindestens einen Auator aufweist.

Weiterhin hat es sich bewährt, wenn das logische Nicht-Oder zwei parallel geschaltete p-leitende OFETs und einen Auator aufweist.

Vorzugsweise weist das logische Nicht-Und zwei in Reihe geschaltete p-leitende OFETs und einen Auator auf.

Vorzugsweise weist der Ringoszillator eine ungerade Anzahl n von obigen Invertern auf, wobei ein Ausgang eines ersten Inverters I₁ mit einem Eingang eines weiteren Inverters I₂ verbunden ist und wobei ein letzter Inverter Iₙ zur Ringbildung mit dem ersten Inverter I₁ verbunden ist.

Die Verwendung eines erfindungsgemäßen Auators als Last-Bauelement in einer elektrischen Schaltung, insbeondere zur Ausbildung eines logischen Gatters, ist ideal.

Im folgenden wird die Erfindung anhand der Figuren 1a bis 6 näher erläutert. So zeigt
- Figur 1a: ein Strom-Spannungs-Diagramm eines ersten Inverters mit klassischem Widerstand und einem OFET nach dem Stand der Technik,
- Figur 1b: ein zu Figur 1a gehörendes Schaltbild des ersten Inverters,
- Figur 2a: ein Strom-Spannungs-Diagramm eines zweiten Inverters mit zwei OFETs nach dem Stand der Technik,
- Figur 2b: ein zu Figur 2a gehörendes Schaltbild des zweiten Inverters,
- Figur 3a: ein Strom-Spannungs-Diagramm eines dritten Inverters mit zwei OFETs nach dem Stand der Technik,
- Figur 3b: ein zu Figur 3a gehörendes Schaltbild des dritten Inverters,
- Figur 4a: den Aufbau eines erfindungsgemäßen Auators im Querschnitt,
- Figur 4b: ein dem Auator zugeordnetes Schaltsymbol,
- Figur 5a: ein Strom-Spannungs-Diagramm eines Inverters gemäß der Erfindung,
- Figur 5b: ein zu Figur 5a gehörendes Schaltbild eines erfindungsgemäßen Inverters und
- Figur 6: Ausführungsbeispiele zu logischen Gattern mit Auatoren.

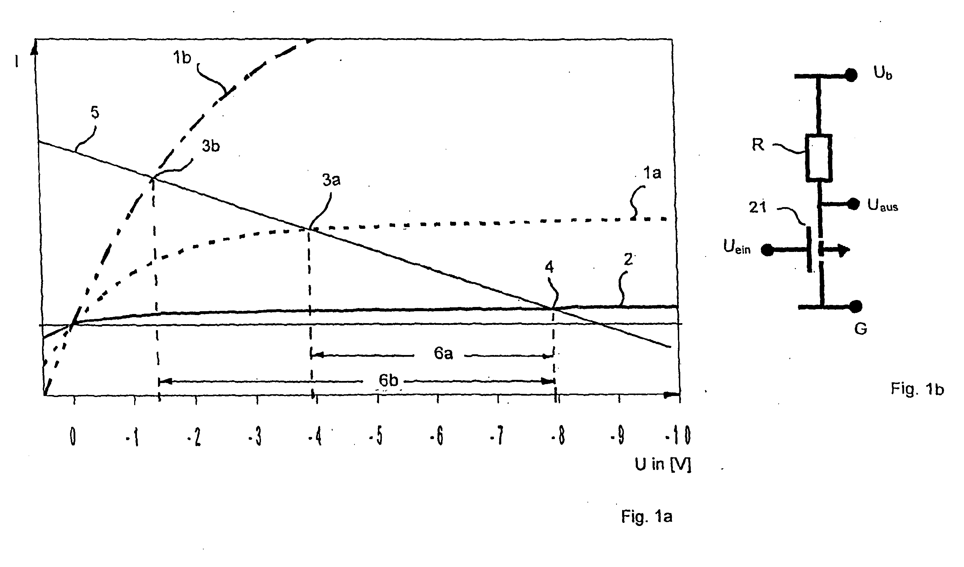

Beim Einsatz des klassischen Widerstands (vgl. Figuren 1a und 1b zum Stand der Technik) schalten die logischen Gatter entweder zu langsam um oder lassen sich nicht ausschalten.

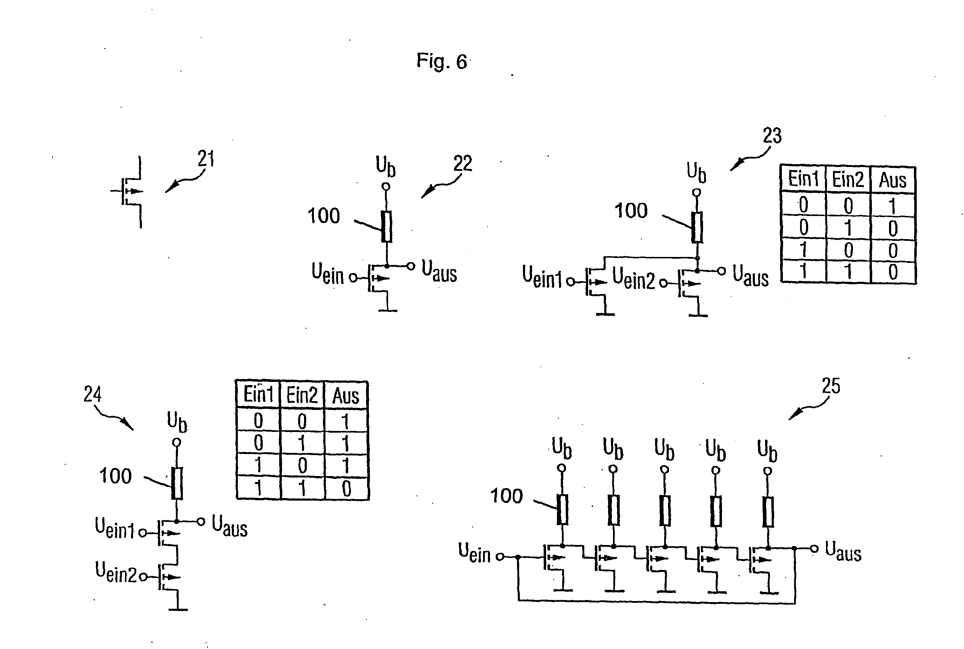

In Fig. 1a sind in einem Strom-Spannungs-Diagramm die Ein- Kennlinie 1b und die Aus-Kennlinie 2 eines Inverters mit p-OFET 21 und klassischem Widerstand R gemäß Figur 1b eingezeichnet. Aus Figur 1b ist die Verschaltung des Inverters ersichtlich, wobei die Versorgungsspannung U_{b}, die Masse G, der p-OFET 21(siehe auch Fig. 6), die Eingangsspannung Uₑᵢₙ und die Ausgangsspannung Uₐᵤₛ sowie der Widerstand R erkennbar sind. Dabei liegt die Gate-Elektrode des p-OFET 21 auf Uₑᵢₙ. Die Kennlinien 1b und 2 gemäß Figur 1a entsprechen dem eingeschalteten und dem ausgeschaltetem Zustand. Die Schnittpunkte 3b und 4 der Kurven 1b und 2 mit der Widerstandslinie 5 des klassischen Widerstands R entsprechen den Schaltpunkten des Inverters. Der Ausgangs-Spannungshub 6b des Inverters ist sehr groß, was bedeutet, dass sich der Inverter gut ein- und ausschalten lässt. Die Umladeströme entsprechen Flächenintegralen zwischen einerseits den Kurven 1b und 5 unter der Kurve 1b im Bereich 6b bzw. andererseits zwischen den Kurven 5 uns 2 unter der Kurve 5 im Bereich 6b.

Die Fig. 1a zeigt weiterhin die Ein-Kennlinie 1a und die Aus-Kennlinie 2 eines Inverters gemäß Figur 1b, welcher mit einem p-OFET 21 betrieben wird, dessen Schichtdicke des organischen Halbleiters fertigungsbedingt geringfügig dünner ausgebildet ist als bei einem p-OFET 21 gemäß der Ein-Kennlinie 1b. Diese Kennlinien 1a und 2 entsprechen dem eingeschalteten und dem ausgeschaltetem Zustand des Inverters. Die Schnittpunkte 3a und 4 der Kurven 1a und 2 mit der Widerstandslinie 5 des klassischen Widerstands R entsprechen den Schaltpunkten des Inverters. Der Ausgangs-Spannungshub 6a des Inverters ist deutlich kleiner, was bedeutet, dass sich der Inverter schlechter ein- und ausschalten lässt. Die Umladeströme entsprechen den Flächenintegralen zwischen einerseits den Kurven 1a und 5 unter der Kurve 1a im Bereich 6a bzw. andererseits zwischen den Kurven 5 und 2 unter der Kurve 5 im Bereich 6a und sind in ihrer Größenordnung gleich groß, aber der Spannungshub 6a nur gering. So lässt sich der Inverter gemäß der Kennlinie 1a mit geringfügig dünnerer Halbleiterschicht des p-OFET 21 nicht ganz ausschalten. Im schlimmsten Fall kann das asymmetrische Laden/Entladen aufgrund der Schwankungen in der Dicke der Halbleiterschicht des p-OFET 21 bewirken, dass die Logikfähigkeit der Schaltung gemäß Figur 1b ganz verloren geht.

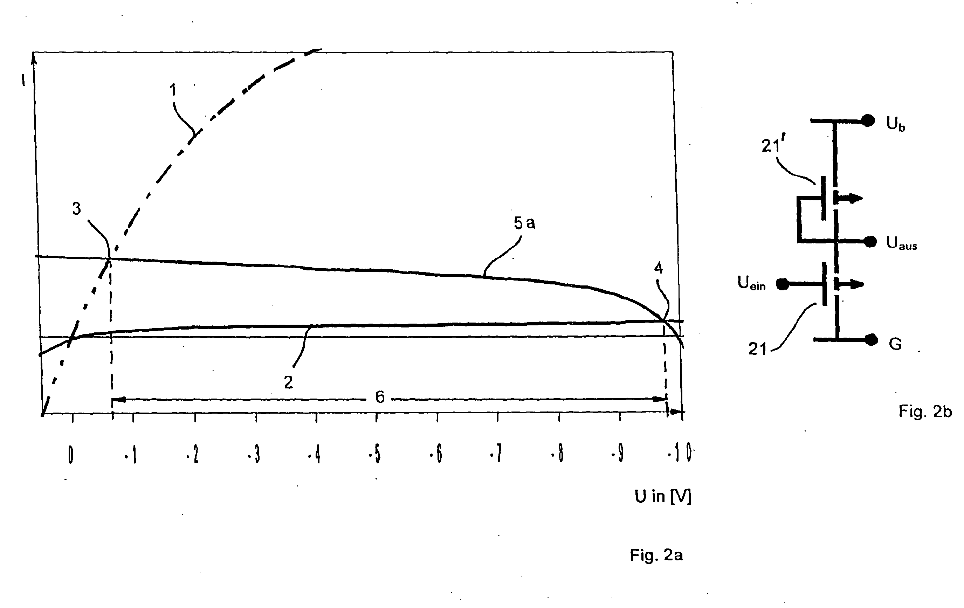

Das Strom-Spannungs-Diagramm eines logischen Gatters aus dem Stand der Technik, welches zwei p-leitende OFETs umfasst, ist in Fig. 2a gezeigt. Aus Figur 2b ist die Verschaltung des Inverters ersichtlich, wobei die Versorgungsspannung U_{b}, die Masse G, zwei p-FETs 21, 21' (siehe auch Fig. 6), die Eingangsspannung Uₑᵢₙ und die Ausgangsspannung Uₐᵤₛ erkennbar sind. Dabei liegt die Gate-Elektrode des p-FET 21 auf Uₑᵢₙ. Die Kennlinien 1 und 2 gemäß Figur 2a entsprechen dem eingeschalteten und dem ausgeschaltetem Zustand. Die Schnittpunkte 3 und 4 der Kurven 1 und 2 mit der Widerstandslinie 5a des p-FET 21' entsprechen den Schaltpunkten des Inverters. Der Ausgangs-Spannungshub 6 des Inverters ist sehr groß, was bedeutet, dass sich der Inverter gut ein- und ausschalten lässt. Die Umladeströme (Flächenintegrale zwischen einerseits den Kurven 1 und 5a unter der Kurve 1 im Bereich 6 bzw. andererseits zwischen den Kurven 5a und 2 unter der Kurve 5a im Bereich 6 entsprechen den Umladeströmen) sind recht unterschiedlich, so dass sich der Inverter aufgrund seiner großen Kapazität nur langsam schalten lässt. Es ist eine diskrete Versorgungsspannung für den Inverter erforderlich, da sonst das Verhältnis der Geometriefaktoren der p-FETs zueinander nicht optimal ist. Unter dem Geometriefaktor wird das Verhältnis von Kanalbreite W zu Kanallänge L (Kanal wird gebildet durch Halbleiterschicht) eines Transistors verstanden. Nachdem der p-FET 21' auf Uₐᵤₛ liegt und somit immer ausgeschaltet ist, steht nur wenig Ladestrom für diesen zur Verfügung. Nimmt man einen Geometriefaktor für den p-FET 21 von 1 und damit eine Kapazität für den p-FET 21 von 1 an und einen Geometriefaktor für den p-FET 21' von 5 und damit eine Kapazität für den p-FET 21' von 5 an, ergibt sich eine 6-fache Gesamtkapazität für den Inverter. Somit resultieren hohe Ladeströme und kleine Ladezeiten.

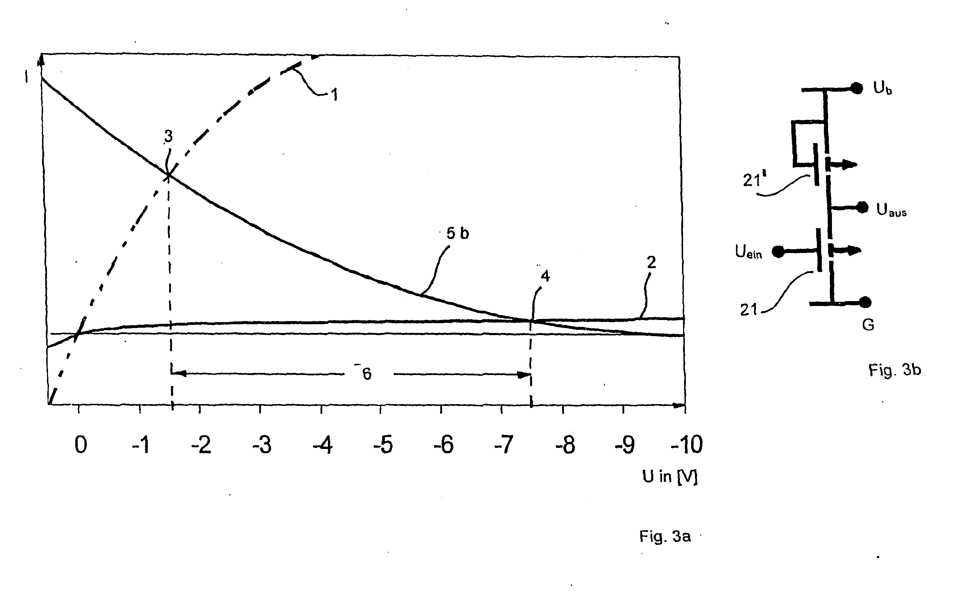

Ein weiteres Strom-Spannungs-Diagramm eines logischen Gatters aus dem Stand der Technik, welches zwei p-leitende OFETs umfasst, ist in Fig. 3a gezeigt. Aus Figur 3b ist die Verschaltung des Inverters ersichtlich, wobei die Versorgungsspannung U_{b}, die Masse G, zwei p-OFETs 21, 21' (siehe auch Fig. 6), die Eingangsspannung Uₑᵢₙ und die Ausgangsspannung Uₐᵤₛ erkennbar sind. Dabei liegt die Gate-Elektrode des p-OFET 21' auf U_{b}. Die Kennlinien 1 und 2 gemäß Figur 3a entsprechen dem eingeschalteten und dem ausgeschaltetem Zustand. Die Schnittpunkte 3 und 4 der Kurven 1 und 2 mit der Widerstandslinie 5b des p-OFET 21' entsprechen den Schaltpunkten des Inverters. Der Ausgangs-Spannungshub 6 des Inverters ist relativ gering, was bedeutet, dass sich der Inverter schlecht ein- und ausschalten lässt. Die Umladeströme (Flächenintegrale zwischen einerseits den Kurven 1 und 5b unter der Kurve 1 im Bereich 6 bzw. andererseits zwischen den Kurven 5b uns 2 unter der Kurve 5b im Bereich 6 entsprechen den Umladeströmen) sind recht ähnlich, so dass sich der Inverter aufgrund seiner großen Ströme bzw. keinen Kapazität relativ schnell schalten lässt. Es ist allerdings eine hohe Versorgungsspannung für den Inverter erforderlich, da der Verstärkungsfaktor nur wenig über 1 geht. Aufgrund der hohen Versorgungsspannung U_{b} ist wiederum die Logik weniger stabil. Ab einer Spannung von etwa 20V oder mehr degradieren die p-OFETs.

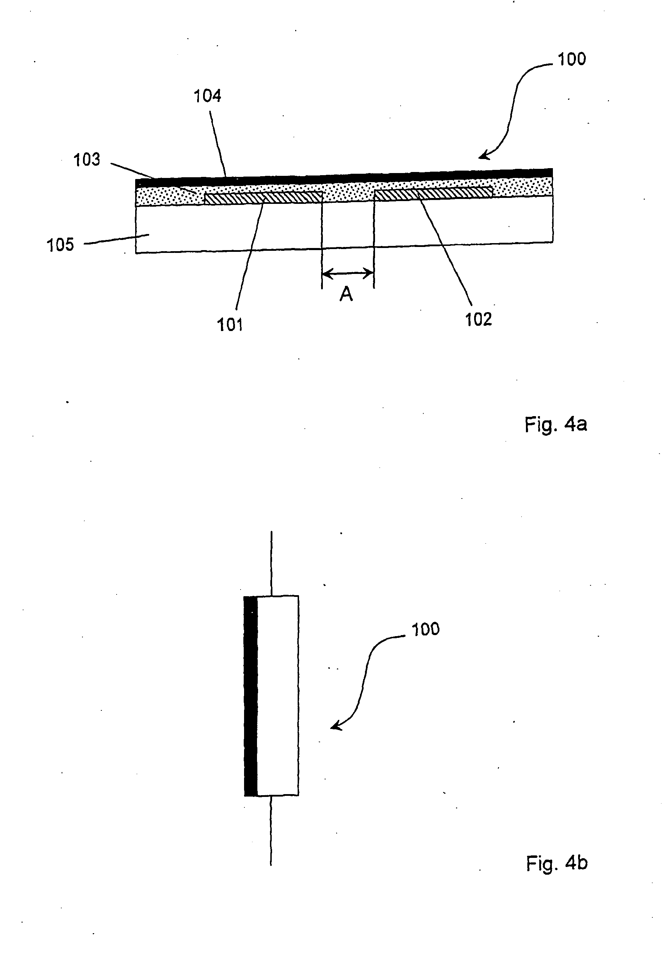

Figur 4a zeigt nun den prinzipiellen Aufbau eines Auators 100 im Querschnitt. Es sind die erste Elektrodenschicht 101 und die zweite Elektrodenschicht 102 gezeigt, welche auf einem flexiblen Träger 105 aus PET angeordnet sind. Der flexible Träger 105 bildet dabei die zweite Isolationsschicht aus. Die erste und die zweite Elektrodenschicht 101, 102 sind aus Gold gebildet, welches auf den Träger 105 in einer Dicke von etwa 40 bis 50nm aufgesputtert ist. Die erste Elektrodenschicht 101 und die zweite Elektrodenschicht 102 sind nebeneinander in gleicher Ebene auf dem Träger 105 angeordnet, wobei sie in einem Abstand A voneinander entfernt angeordnet sind. Der Abstand A beträgt hier etwa 10µm. Eine organische Halbleiterschicht 103 aus Polythiophen bedeckt die erste und die zweite Elektrodenschicht 101, 102 und überspannt auch den Abstand A. Eine erste Isolatorschicht 104 aus PMMA bedeckt die organische Halbleiterschicht 103 auf ihrer den beiden Elektrodenschichten 101, 102 abgewandten Seite.

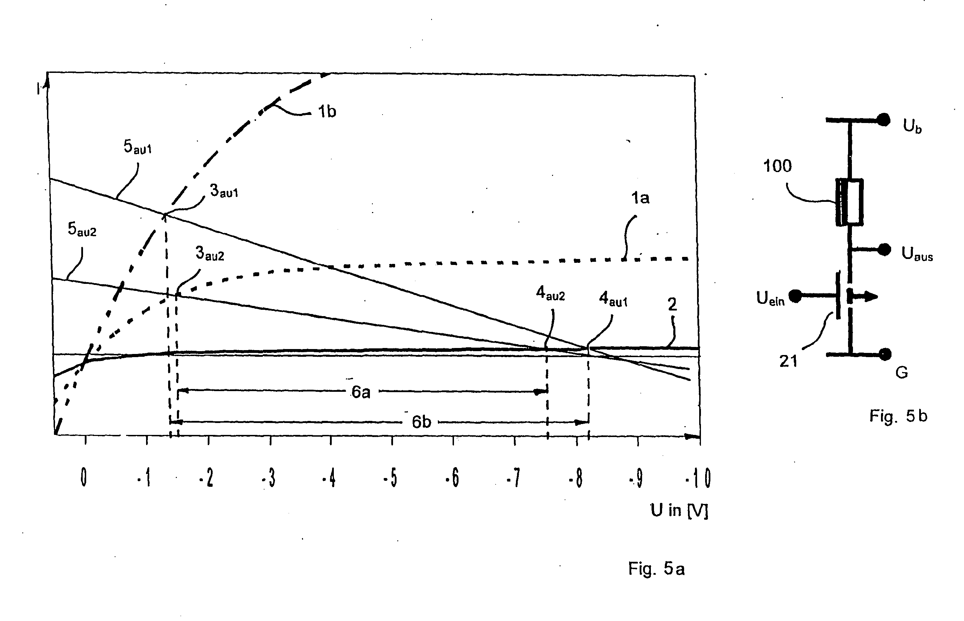

Figur 4b zeigt ein, dem Auator 100 zugeordnetes neues Schaltsymbol, welches nachfolgend in der Darstellung von logischen Gattern (siehe Fig. 5b und 6) eingesetzt wird.

Figur 5a zeigt ein Strom-Spannungs-Diagramm eines gemäß der Erfindung gebildeten Inverters, welcher einen p-leitenden OFET 21 und einen Auator 100 umfasst. In Fig. 5a sind im Strom-Spannungs-Diagramm die Ein- Kennlinie 1b und die Aus-Kennlinie 2 eines Inverters gemäß Figur 5b eingezeichnet. Aus Figur 5b ist die Verschaltung des Inverters ersichtlich, wobei die Versorgungsspannung U_{b}, die Masse G, ein p-OFET 21, die Eingangsspannung Uₑᵢₙ und die Ausgangsspannung Uₐᵤₛ sowie der Auator 100 erkennbar sind. Dabei liegt die Gate-Elektrode des p-FET 21 auf Uₑᵢₙ. Die Kennlinien 1b und 2 gemäß Figur 5a entsprechen dem eingeschalteten und dem ausgeschaltetem Zustand. Die Schnittpunkte 3ₐᵤ₁ und 4ₐᵤ₁ der Kurven 1b und 2 mit der Widerstandslinie 5ₐᵤ₁ des Auators 100 entsprechen den Schaltpunkten des Inverters. Der Ausgangs-Spannungshub 6b des Inverters ist groß, was bedeutet, dass sich der Inverter gut ein- und ausschalten lässt. Die Umladeströme (Flächenintegrale zwischen einerseits den Kurven 1b und 5ₐᵤ₁ unter der Kurve 1b im Bereich 6b bzw. andererseits zwischen den Kurven 5ₐᵤ₁ und 2 unter der Kurve 5ₐᵤ₁ im Bereich 6b entsprechen den Umladeströmen) sind unterschiedlich, was bedeutet, dass sich der Inverter schneller auf "High" schalten lässt, jedoch langsamer auf "Low".

Die Halbleiterschicht des Auators 100 wurde dabei drucktechnisch und gleichzeitig mit der Halbleiterschicht des p-OFET 21 ausgebildet, so dass eine gleiche Schichtdicke der Halbleiterschicht in beiden Bauelementen erzeugt wurde.

Die Fig. 5a zeigt weiterhin die Ein-Kennlinie 1a und die Aus-Kennlinie 2 eines Inverters gemäß Figur 5b, welcher mit einem p-OFET 21 betrieben wird, dessen Schichtdicke des Halbleiters fertigungsbedingt geringfügig dünner ausgebildet ist als bei einem p-OFET 21 gemäß der Ein-Kennlinie 1b. Die Halbleiterschicht des Auators 100 wurde dabei drucktechnisch und gleichzeitig mit der Halbleiterschicht des p-OFET 21 ausgebildet, so dass auch hier eine gleiche Schichtdicke der Halbleiterschicht in beiden Bauelementen erzeugt wurde.

Die Kennlinien 1a und 2 entsprechen dem eingeschalteten und dem ausgeschaltetem Zustand des Inverters. Deutlich wird aus dieser Darstellung erkennbar, dass der Auator seine elektrischen Eigenschaften mitskaliert, wenn Schwankungen in der Schichtdicke der drucktechnisch gebildeten Halbleiterschicht auftreten. Die Schnittpunkte 3ₐᵤ₂ und 4ₐᵤ₂ der Kurven 1a und 2 mit der Widerstandslinie 5ₐᵤ₂ des Auators 100 entsprechen den Schaltpunkten des Inverters und sind gegenüber den Schnittpunkten 3ₐᵤ₁ und 4ₐᵤ₁ nur geringfügig verschoben. Der Ausgangs-Spannungshub 6a des Inverters ist somit nur geringfügig kleiner als der Spannungshub 6b, was bedeutet, dass der Auator 100 in der Lage ist, die elektrischen Eigenschaften von Invertern mit Schwankungen in der Schichtdicke der Halbleiterschicht aneinander anzugleichen. Die Umladeströme (Flächenintegrale zwischen einerseits den Kurven 1a und 5ₐᵤ₂ unter der Kurve 1a im Bereich 6a bzw. andererseits zwischen den Kurven 5ₐᵤ₂ uns 2 unter der Kurve 5ₐᵤ₂ im Bereich 6a entsprechen den Umladeströmen) sind in ihrem Größenverhältnis zueinander nahezu unverändert, so dass auch im Schaltverhalten des Inverters keine signifikanten Änderungen auftreten.

In Fig. 6 sind einige Ausführungsbeispiele zu logischen Gattern, die Auatoren umfassen, gezeigt:

Inverter 22, Nicht-Oder 23, Nicht-Und 24, Ringoszillator 25. Das Schaltzeichen 21 symbolisiert dabei den p-leitenden OFET. Der Inverter 22 kann durch eine Zusammenschaltung eines OFET mit einem Auator gebildet sein. Ein an den Eingang angelegtes Signal ("High" oder "Low") wird dabei umgedreht (invertiert) und liegt danach am Ausgang an (als "Low" oder "High"). Um ein logisches Nicht-Oder zu erhalten, können zwei Transistoren parallel geschaltet werden. Die Zustände werden durch Anlegen einer Eingangsspannung gemäss der Tabelle ("Low" = "0"; "High" = "1") zum Ausgang weitergeleitet. Analog funktioniert ein Nicht-Und, welches durch in Reihe geschaltete Transistoren realisiert werden kann.

Eine nicht.gezeigte Ausführungsform des logischen Gatters ist z. B. ein Flip-Flop, das ebenfalls aus OFETs und Auatoren aufgebaut werden kann.

Es sei hinzugefügt, dass der Fachmann den Auator, ohne erfinderisch tätig werden zu müssen, in unzähligen weiteren elektrischen Schaltungen einsetzen kann.

## Patentansprüche

1. Organisches Last-Bauelement mit:
- lediglich zwei Elektrodenschichten, einer ersten Elektrodenschicht (101)aus einem ersten elektrisch leitenden Material und einer zweiten Elektrodenschicht (102) aus einem zweiten elektrisch leitenden Material,
- einer organischen Halbleiterschicht (103) und
- mindestens einer Isolatorschicht aus einem dielektrischen Material, wobei
a) die erste Elektrodenschicht (101) und die zweite Elektrodenschicht (102) in gleicher Ebene nebeneinander mit einem Abstand A angeordnet sind, wobei der Abstand A im Bereich von 1µm bis 100µm gewählt ist,
b) die organische Halbleiterschicht (103) die erste Elektrodenschicht (101) und die zweite Elektrodenschicht (102) zumindest teilweise bedeckt und weiterhin den Abstand A überspannt,
c) eine erste Isolatorschicht (104) die organische Halbleiterschicht (103) auf ihrer den beiden Elektrodenschichten (101, 102) abgewandten Seite bedeckt, und wobei
d) die organische Halbleiterschicht (103) eine Schichtdicke im Bereich von 1nm bis 200nm aufweist.

2. Organisches Bauelement nach Anspruch 1,
**dadurch gekennzeichnet,**
**dass** das Last-Bauelement (100) eine zweite Isolatorschicht (105) aufweist, welche die organische Halbleiterschicht (103) im Bereich des Abstandes A zwischen der ersten und der zweiten Elektrodenschicht (101, 102) bedeckt.

3. Organisches Bauelement nach Anspruch 2,
**dadurch gekennzeichnet,**
**dass** die zweite Isolatorschicht (105) weiterhin die der organischen Halbleiterschicht (103) abgewandte Seite der beiden Elektrodenschichten (101, 102) bedeckt.

4. Organisches Bauelement nach Anspruch 3,
**dadurch gekennzeichnet,**
**dass** die zweite Isolatorschicht (105) als mechanischer Träger, insbesondere als flexibler mechanischer Träger, fungiert.

5. Organisches Bauelement nach einem der Ansprüche 1 bis 4,
**dadurch gekennzeichnet,**
**dass** die Elektrodenschichten (101, 102) jeweils eine Schichtdicke im Bereich von 1nm bis 1µm aufweisen.

6. Organisches Bauelement nach einem der Ansprüche 1 bis 5,
**dadurch gekennzeichnet,**
**dass** das erste und das zweite elektrisch leitende Material aus Metall, einer Metall-Legierung, einem leitfähigen Polymer, einem leitfähigen Kleber, einer leitfähigen Substanz mit leitfähigen anorganischen Partikeln in einer Polymermatrix oder aus einer Paste/Tinte enthaltend elektrisch leitfähige Partikel gebildet ist.

7. Organisches Bauelement nach Anspruch 6,
**dadurch gekennzeichnet,**
**dass** die Elektrodenschichten (101, 102) mehrschichtig ausgebildet sind.

8. Organisches Bauelement nach Anspruch 7,
**dadurch gekennzeichnet,**
**dass** die Elektrodenschichten (101, 102) aus mehreren Metallschichten und/oder mehreren Polymerschichten und/oder mehreren Pasten/Tinten-Schichten ausgebildet sind.

9. Organisches Bauelement nach einem der Ansprüche 1 bis 8,
**dadurch gekennzeichnet,**
**dass** die erste Isolatorschicht (104) eine Schichtdicke im Bereich von 1nm bis 10µm aufweist.

10. Organisches Bauelement nach einem der Ansprüche 2 bis 9,
**dadurch gekennzeichnet,**
**dass** die zweite Isolatorschicht (105) eine Schichtdicke von mindestens 1µm aufweist.

11. Organisches Bauelement nach einem der Ansprüche 1 bis 10,
**dadurch gekennzeichnet,**
**dass** die organische Halbleiterschicht (103) aus Polythiophen, Polyterthiophen, Polyfluoren, Pentacen, Tetracen, Oligothiophen, anorganischem Silizium eingebettet in einer Polymermatrix, oder Polyarylamin gebildet ist.

12. Organisches Bauelement nach einem der Ansprüche 1 bis 10,
**dadurch gekennzeichnet,**
**dass** die erste Isolatorschicht (104) als eine organische Polymerschicht ausgebildet ist.

13. Organisches Bauelement nach Anspruch 12,
**dadurch gekennzeichnet,**
**dass** die organische Polymerschicht aus Polymethylmethacrylat (PMMA), PVP, PHS, PS, Polystyrolcopolymeren, Harnstoffharzen oder PMMA-Copolymeren gebildet ist.

14. Organisches Bauelement nach einem der Ansprüche 1 bis 13,
**dadurch gekennzeichnet,**
**dass** zumindest die organische Halbleiterschicht (103) mittels einer Flüssigkeit gebildet ist.

15. Elektrische Schaltung umfassend mindestens ein Last-Bauelement (100) gemäß einem der Ansprüche 1 bis 13,
**dadurch gekennzeichnet,**
**dass** die elektrische Schaltung ein logisches Gatter bildet.

16. Elektrische Schaltung gemäß Anspruch 15,
**dadurch gekennzeichnet,**
**dass** das logische Gatter mindestens ein Treiber-Bauelement und das mindestens eine Last-Bauelement aufweist, wobei das mindestens eine Treiber-Bauelement durch einen Transistor bereitgestellt ist.

17. Elektrische Schaltung gemäß Anspruch 16,
**dadurch gekennzeichnet,**
**dass** der Transistor eine Halbleiterschicht aufweist.

18. Elektrische Schaltung gemäß einem der Ansprüche 16 oder 17,
**dadurch gekennzeichnet,**
**dass** als Transistor ein organischer Feldeffekt-Transistor (OFET) eingesetzt ist.

19. Elektrische Schaltung gemäß einem der Ansprüche 15 bis 18,
**dadurch gekennzeichnet,**
**dass** das logische Gatter einen Inverter, ein logisches Nicht-Oder, ein logisches Nicht-Und oder einen Ringoszillator bildet.

20. Elektrische Schaltung gemäß Anspruch 19,
**dadurch gekennzeichnet,**
**dass** der Inverter mindestens einen p-leitenden OFET (21) und das mindestens ein Last-Bauelement (100) aufweist.

21. Elektrische Schaltung gemäß Anspruch 19,
**dadurch gekennzeichnet,**
**dass** das logische Nicht-Oder zwei parallel geschaltete p-leitende OFETs (21) und ein Last-Bauelement (100) aufweist.

22. Elektrische Schaltung gemäß Anspruch 19,
**dadurch gekennzeichnet,**
**dass** das logische Nicht-Und zwei in Reihe geschaltete p-leitende OFETs (21) und ein Last-Bauelement(100) aufweist.

23. Elektrische Schaltung gemäß Anspruch 19,
**dadurch gekennzeichnet,**
**dass** der Ringoszillator eine ungerade Anzahl n von Invertern gemäß Anspruch 21 aufweist, wobei ein Ausgang eines ersten Inverters I₁ mit einem Eingang eines weiteren Inverters I₂ verbunden ist und wobei ein letzter Inverter Iₙ zur Ringbildung mit dem ersten Inverter I₁ verbunden ist.

24. Verfahren zur Herstellung einer elektrischen Schaltung gemäß Anspruch 17 oder Anspruch 17 in Verbindung mit einem der Ansprüche 18 bis 23,
**dadurch gekennzeichnet,**
**dass** die organische Halbleiterschicht (103) des Last-Bauelements (100) gleichzeitig und in einem Arbeitsgang mit der Halbleiterschicht des Transistors ausgebildet wird.

## Claims

1. Organic load component, comprising:
- merely two electrode layers, a first electrode layer (101) formed of a first electrically conductive material and a second electrode layer (102) formed of a second electrically conductive material,
- an organic semiconductor layer (103) and
- at least one insulator layer formed of a dielectric material, wherein
a) the first electrode layer (101) and the second electrode layer (102) are arranged in the same plane beside one another at a distance A, the distance A being selected in the range of 1 µm to 100 µm,
b) the organic semiconductor layer (103) covers the first electrode layer (101) and the second electrode layer (102), at least in part, and also spans the distance A,
c) a first insulator layer (104) covers the organic semiconductor layer (103) on its side remote from the two electrode layers (101, 102), and wherein
d) the organic semiconductor layer (103) has a layer thickness in the range of 1 nm to 200 nm.

2. Organic component according to claim 1, **characterised in that** the load component (100) has a second insulator layer (105) which covers the organic semiconductor layer (103) in the region of the distance A between the first and the second electrode layer (101, 102).

3. Organic component according to claim 2, **characterised in that** the second insulator layer (105) also covers the side of the two electrode layers (101, 102) remote from the organic semiconductor layer (103).

4. Organic component according to claim 3, **characterised in that** the second insulator layer (105) acts as a mechanical substrate, in particular as a flexible mechanical substrate.

5. Organic component according to one of claims 1 to 4, **characterised in that** the electrode layers (101, 102) each have a layer thickness in the range of 1 nm to 1 µm.

6. Organic component according to one of claims 1 to 5, **characterised in that** the first and the second electrically conductive material is formed from metal, a metal alloy, a conductive polymer, a conductive adhesive, a conductive substance with conductive inorganic particles in a polymer matrix, or from a paste/ink containing electrically conductive particles.

7. Organic component according to claim 6, **characterised in that** the electrode layers (101, 102) are each formed in a multi-layered manner.

8. Organic component according to claim 7, **characterised in that** the electrode layers (101, 102) are formed of a plurality of metal layers and/or a plurality of polymer layers and/or a plurality of paste/ink layers.

9. Organic component according to one of claims 1 to 8, **characterised in that** the first insulator layer (104) has a layer thickness in the range of 1 nm to 10 µm.

10. Organic component according to one of claims 2 to 9, **characterised in that** the second insulator layer (105) has a layer thickness of at least 1 µm.

11. Organic component according to one of claims 1 to 10, **characterised in that** the organic semiconductor layer (103) is formed of polythiophene, polyterthiophene, polyfluorene, pentacene, tetracene, oligothiophene, inorganic silicon embedded in a polymer matrix, or polyarylamine.

12. Organic component according to one of claims 1 to 10, **characterised in that** the first insulator layer (104) is formed as an organic polymer layer.

13. Organic component according to claim 12, **characterised in that** the organic polymer layer is formed of polymethyl methacrylate (PMMA), PVP, PHS, PS, polystyrene copolymers, urea resins or PMMA copolymers.

14. Organic component according to one of claims 1 to 13, **characterised in that** at least the organic semiconductor layer (103) is formed by means of a liquid.

15. Electric circuit, comprising at least one load component (100) according to one of claims 1 to 13, **characterised in that** the electric circuit is a logic gate.

16. Electric circuit according to claim 15, **characterised in that** the logic gate comprises at least one driver component and the at least one load component, the at least one driver component being provided by a transistor.

17. Electric circuit according to claim 16, **characterised in that** the transistor is a semiconductor layer.

18. Electric circuit according to one of claims 16 or 17, **characterised in that** an organic field-effect transistor (OFET) is used as a transistor.

19. Electric circuit according to one of claims 15 to 18, **characterised in that** the logic gate forms an inverter, a logic NOR, a logic NAND, or a ring oscillator.

20. Electric circuit according to claim 19, **characterised in that** the inverter comprises at least one p-conducting OFET (21) and the at least one load component (100).

21. Electric circuit according to claim 19, **characterised in that** the logic NOR comprises two p-conducting OFETs (21) connected in parallel and one load component (100).

22. Electric circuit according to claim 19, **characterised in that** the logic NAND comprises two p-conducting OFETs (21) connected in series and one load component (100)

23. Electric circuit according to claim 19, **characterised in that** the ring oscillator comprises an odd number n of inverters according to claim 21, an output of a first inverter I₁ being connected to an input of a further inverter I₂, and a last inverter Iₙ being connected to the first inverter I₁ to form a ring.

24. Method for producing an electric circuit according to claim 17 or claim 17 in conjunction with one of claims 18 to 23, **characterised in that** the organic semiconductor layer (103) of the load component (100) is formed simultaneously and in a single processing step with the semiconductor layer of the transistor.

## Revendications

1. Composant organique de charge comprenant :
- uniquement deux couches d'électrodes, une première couche d'électrodes (101) constituée d'un premier matériau électriquement conducteur et une deuxième couche d'électrodes (102) constituée d'un deuxième matériau électriquement conducteur,
- une couche de semi-conducteur organique (103) et
- au moins une couche d'isolant constituée d'un matériau diélectrique,
a) la première couche d'électrodes (101) et la deuxième couche d'électrodes (102) étant disposées côte à côte sur le même plan séparées par une distance A, la distance A étant choisie dans la plage allant de 1 µm à 100 µm,
b) la couche de semi-conducteur organique (103) recouvrant au moins partiellement la première couche d'électrodes (101) et la deuxième couche d'électrodes (102) et s'étirant également sur la distance A,
c) une première couche d'isolant (104) recouvrant la couche de semi-conducteur organique (103) sur la face opposée aux deux couches d'électrodes (101, 102), et
d) la couche de semi-conducteur organique (103) présentant une épaisseur de couches située dans la plage allant de 1 nm à 200 nm.

2. Composant organique selon la revendication 1,
**caractérisé en ce**
**que** le composant de charge (100) présente une deuxième couche d'isolant (105) qui recouvre la couche de semi-conducteur organique (103) dans la zone de la distance A séparant la première et la deuxième couche d'électrodes (101, 102).

3. Composant organique selon la revendication 2,
**caractérisé en ce**
**que** la deuxième couche d'isolant (105) recouvre également la face des deux couches d'électrodes (101, 102) opposée à la couche de semi-conducteur organique (103).

4. Composant organique selon la revendication 3,
**caractérisé en ce**
**que** la deuxième couche d'isolant (105) fait office de support mécanique, en particulier de support mécanique flexible.

5. Composant organique selon l'une des revendications 1 à 4,
**caractérisé en ce**
**que** les couches d'électrodes (101, 102) présentent respectivement une épaisseur de couche située dans la plage allant de 1 nm à 1 µm.

6. Composant organique selon l'une des revendications 1 à 5,
**caractérisé en ce**
**que** le premier et le deuxième matériaux électriquement conducteurs sont formés à partir d'un métal, d'un alliage de métaux, d'un polymère conducteur, d'un adhésif conducteur, d'une substance conductrice ayant des particules inorganiques conductrices dans une matrice polymère ou à partir d'une pâte/encre contenant des particules électriquement conductrices.

7. Composant organique selon la revendication 6,
**caractérisé en ce**
**que** les couches d'électrodes (101, 102) sont constituées de plusieurs couches.

8. Composant organique selon la revendication 7,
**caractérisé en ce**
**que** les couches d'électrodes (101, 102) sont constituées de plusieurs couches de métal et/ou de plusieurs couches de polymère et/ou de plusieurs couches de pâtes/encres.

9. Composant organique selon l'une des revendications 1 à 8,
**caractérisé en ce**
**que** la première couche d'isolant (104) présente une épaisseur de couche dans la plage allant de 1 nm à 10 µm.

10. Composant organique selon l'une des revendications 2 à 9,
**caractérisé en ce**
**que** la deuxième couche d'isolant (105) présente une épaisseur de couche d'au moins 1 µm.

11. Composant organique selon l'une des revendications 1 à 10,
**caractérisé en ce**
**que** la couche de semi-conducteur organique (103) est constituée de polythiophène, polyterthiophène, polyfluorène, pentacène, tétracène, oligothiophène, silicium inorganique incorporé dans une matrice de polymère, ou de polyarylamine.

12. Composant organique selon l'une des revendications 1 à 10,
**caractérisé en ce**
**que** la première couche d'isolant (104) est conçue sous la forme d'une couche de polymère organique.

13. Composant organique selon la revendication 12,
**caractérisé en ce**
**que** la couche de polymère organique est constituée de polyméthylméthacrylate (PMMA), PVP, PHS, PS, copolymères de polystyrène, résines d'urée ou copolymères de PMMA.

14. Composant organique selon l'une des revendications 1 à 13,
**caractérisé en ce**
**qu'**au moins la couche de semi-conducteur organique (103) est formée au moyen d'un liquide.

15. Circuit électrique comprenant au moins un composant de charge (100) selon l'une des revendications 1 à 13,
**caractérisé en ce**
**que** le circuit électrique constitue une porte logique.

16. Circuit électrique selon la revendication 15,
**caractérisé en ce**
**que** la porte logique présente au moins un composant propulseur et le au moins un élément de charge, le au moins un composant propulseur étant mis à disposition par un transistor.

17. Circuit électrique selon la revendication 16,
**caractérisé en ce**
**que** le transistor présente une couche de semi-conducteur.

18. Circuit électrique selon l'une des revendications 16 ou 17,
**caractérisé en ce**
**que** l'on met en oeuvre à titre de transistor un transistor organique à effet de champ (OFET).

19. Circuit électrique selon l'une des revendications 15 à 18,
**caractérisé en ce**
**que** la porte logique forme un inverseur, un non-ou logique, un non-et logique ou un oscillateur en anneau.

20. Circuit électrique selon la revendication 19,
**caractérisé en ce**
**que** l'inverseur présente au moins un OFET conducteur p (21) et le au moins un composant de charge (100).

21. Circuit électrique selon la revendication 19,
**caractérisé en ce**
**que** le non-ou logique comprend deux OFET (21) conducteurs p montés en parallèle et un composant de charge (100).

22. Circuit électrique selon la revendication 19,
**caractérisé en ce**
**que** le non-et logique comprend deux OFET (21) conducteurs p montés en série et un composant de charge (100).

23. Circuit électrique selon la revendication 19,
**caractérisé en ce**
**que** l'oscillateur en anneau présente un nombre impair n d'inverseurs selon la revendication 21, une sortie d'un premier inverseur I₁ étant reliée à une entrée d'un deuxième inverseur I₂ et un dernier inverseur Iₙ étant relié au premier inverseur I₁ pour la formation d'un anneau.

24. Procédé de fabrication d'un circuit électrique selon la revendication 17 ou la revendication 17 en relation avec l'une des revendications 18 à 23,
**caractérisé en ce**
**que** la couche de semi-conducteur organique (103) du composant de charge (100) est formée simultanément et en une opération avec la couche de semi-conducteur du transistor.
